(19) Europäisches Patentamt
European Patent Office
Office européen des brevets

(11) **EP 3 699 315 A1**

(12) **DEMANDE DE BREVET EUROPEEN**

(43) Date de publication:
**26.08.2020 Bulletin 2020/35**

(51) Int Cl.:
*C23C 14/06* (2006.01)   *H01G 11/00* (2013.01)
*H01M 4/66* (2006.01)   *H01M 4/86* (2006.01)

(21) Numéro de dépôt: **20158171.7**

(22) Date de dépôt: **19.02.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **21.02.2019 FR 1901747**

(71) Demandeurs:
• **SAFT**
  **92300 Lavallois-Perret (FR)**
• **H.E.F.**
  **42160 Andrézieux-Bouthéon (FR)**

(72) Inventeurs:
• **LAVAUD, Céline**
  **33300 BORDEAUX (FR)**
• **TESSIER, Cécile**
  **33520 BRUGES (FR)**
• **DUBOST, Laurent**
  **42330 CHAMBOEUF (FR)**
• **MARTIN, Michel, Joseph, Pierre, Marie**
  **38780 SEPTEME (FR)**

(74) Mandataire: **Hirsch & Associés**
  **137, rue de l'Université**
  **75007 Paris (FR)**

(54) **FEUILLARD MÉTALLIQUE POUR ÉLECTRODE D'ÉLÉMENT ÉLECTROCHIMIQUE COMPRENANT UN MATÉRIAU À BASE DE TI, C ET H**

(57)    Un feuillard métallique comprenant sur au moins l'une de ses faces une couche d'un matériau comprenant :
- un métal ou un alliage de métaux,
- du carbone,
- de l'hydrogène,
et éventuellement de l'oxygène,
- le pourcentage atomique du métal ou des métaux de l'alliage dans le matériau allant de 10 à 60%,
- le pourcentage atomique de carbone dans le matériau allant de 35 à 70 %,
- le pourcentage atomique d'hydrogène dans le matériau allant de 2 à 20 %,
- le pourcentage atomique d'oxygène si présent dans le matériau étant inférieur ou égal à 10 %.
   Le feuillard métallique peut être utilisé dans la fabrication d'une cathode d'un élément électrochimique lithium-ion. Le dépôt de cette couche permet de réduire la résistance interne de l'élément.

[Fig. 3]

EP 3 699 315 A1

**Description**

**Domaine technique**

Le domaine technique de l'invention est celui des collecteurs de courant, notamment ceux destinés à être utilisés dans l'électrode positive (ou cathode) d'un élément électrochimique, de préférence de type lithium-ion.

**Etat de la technique**

Le terme « élément » utilisé dans ce qui suit désigne un élément électrochimique. Les termes « élément » et « élément électrochimique » sont utilisés de manière interchangeable dans la présente description.

Un élément électrochimique comprend généralement un faisceau électrochimique comportant une alternance de cathodes et d'anodes encadrant un séparateur imprégné d'électrolyte. Chaque électrode est constituée d'un collecteur de courant métallique supportant sur au moins une de ses faces un film de matière active comprenant au moins une matière active et généralement un liant et un composé conducteur électronique.

La cathode d'un élément de type Li-ion est constituée d'une composition de matière active cathodique enduite sur un collecteur de courant, généralement constitué d'aluminium ou d'un alliage à base d'aluminium. Ce feuillard d'aluminium s'oxyde légèrement au contact de l'air et présente donc en surface une couche d'alumine $Al_2O_3$. Dans l'élément, au contact de l'électrolyte et du sel de cet électrolyte, la couche d'alumine va se fluorer et se transformer en $AlF_3$. Cette nouvelle couche $AlF_3$ est électriquement isolante. Elle a donc tendance à gêner le passage des électrons en augmentant la résistance de contact entre la composition de matière active cathodique et le feuillard d'aluminium. On observe qu'un élément Li-ion comportant une cathode dont le collecteur de courant est en aluminium verra sa résistance interne augmenter dans le temps au fur et à mesure du contact du collecteur de courant avec l'électrolyte. L'augmentation de résistance interne se traduit d'une part par une baisse des performances électriques de l'élément lorsque celui-ci est utilisé en charge ou en décharge à un courant (ou régime) élevé, et d'autre part par un échauffement plus important en cyclage.

Afin de réduire la perte de conductivité électrique entre la composition de matière active et le collecteur de courant en aluminium, on a recours au dépôt d'une couche à la surface du collecteur de courant. Cette couche peut être à base de carbone ou à base d'un carbure métallique, tel le carbure de tungstène. A cet égard, le document US 2011/0200884 décrit un procédé permettant de réduire la résistance de contact entre un feuillard en aluminium et une composition de matière active déposée à la surface du feuillard. Ce procédé, qui est effectué sous vide, comprend une étape de décapage partiel de la couche d'oxyde d'alumine à la surface du feuillard d'aluminium suivie d'une étape de pulvérisation cathodique d'un métal ou d'un carbure métallique sur la surface partiellement décapée du feuillard, typiquement du tungstène (W) ou du carbure de tungstène (WC).

L'inconvénient de cet état de l'art est que l'utilisation du tungstène ou de son carbure pose de nombreux problèmes. Ainsi, le tungstène est un élément plutôt rare, la fabrication d'une cible de pulvérisation en WC coûteuse et sa mise en oeuvre délicate. En outre, les contraintes de compression sont élevées dans les couches minces comportant du tungstène à cause de la masse importante des atomes de W. Ceci est préjudiciable au vieillissement et à la mise en oeuvre des feuillards revêtu de ce matériau. Pour ces raisons, on recherche de nouveaux moyens de réduire la résistance de contact entre un feuillard en aluminium et une composition de matière active déposée à la surface de ce feuillard.

**Résumé de l'invention**

A cet effet, l'invention propose un feuillard métallique comprenant sur au moins l'une de ses faces une couche d'un matériau comprenant :

- un métal ou un alliage de métaux,
- du carbone,
- de l'hydrogène,
  et éventuellement de l'oxygène,

le pourcentage atomique du métal ou des métaux de l'alliage dans le matériau allant de 10 à 60%,
le pourcentage atomique de carbone dans le matériau allant de 35 à 70 %,
le pourcentage atomique d'hydrogène dans le matériau allant de 2 à 20 %,
le pourcentage atomique d'oxygène si présent dans le matériau étant inférieur ou égal à 10 %.

Selon un mode de réalisation, le matériau comprend en outre de l'azote.

Selon un mode de réalisation, le pourcentage atomique du métal ou des métaux de l'alliage dans le matériau va de 30 à 50%, de préférence de 40 à 50%.

Selon un mode de réalisation, le pourcentage atomique de carbone dans le matériau va de 40 à 60%, de préférence de 45 à 55%.

Selon un mode de réalisation, le pourcentage atomique d'hydrogène dans le matériau va de 3 à 15%, de préférence de 3 à 8%.

Selon un mode de réalisation, le matériau comprend de l'oxygène, et le pourcentage atomique d'oxygène dans le matériau est inférieur ou égal à 5%, de préférence inférieur ou égal à 2%, de préférence encore inférieur ou égal à 1%.

Selon un mode de réalisation,

- le pourcentage atomique du métal ou des métaux de l'alliage dans le matériau va de 40 à 50%,
- le pourcentage atomique de carbone dans le matériau va de 40 à 55 %,
- le pourcentage atomique d'hydrogène dans le matériau va de 3 à 8 %, et
- le pourcentage atomique d'oxygène dans le matériau est inférieur ou égal à 5 %.

Selon un mode de réalisation, le métal du matériau est choisi parmi Ti, Cr, Zr, Fe, Ni, de préférence Ti.

Selon un mode de réalisation, l'alliage du matériau est composé de plusieurs métaux choisis parmi Ti, Zr, Fe, Cr et Ni.

Selon un mode de réalisation, l'épaisseur de la couche va de 30 à 200 nm ou va de 50 à 150 nm ou va de 50 à 100 nm.

Selon un mode de réalisation, le feuillard métallique est en aluminium ou en alliage à base d'aluminium, ou en cuivre ou en alliage à base de cuivre.

L'invention a également pour objet une cathode d'un élément électrochimique comprenant un feuillard tel que décrit ci-avant.

La couche conductrice déposée sur le feuillard est stable dans le temps dans l'électrolyte organique d'un élément Li-ion. La présence de cette couche conductrice améliore le contact entre la matière active cathodique et le feuillard, ce qui se traduit par :

- une résistance interne plus faible de l'élément,
- une meilleure capacité en décharge de l'élément,
- une plus faible polarisation de l'élément.

Grâce à une résistance interne plus faible de l'élément, celui-ci s'échauffe moins lorsqu'il est utilisé dans un cyclage comportant peu ou pas de phases de repos. De plus, la présence de la couche conductrice sur le feuillard permet de protéger la surface de celui-ci contre la corrosion alcaline en voie aqueuse.

L'invention a également pour objet un élément électrochimique comprenant une cathode et une anode, la cathode ou l'anode comprenant un feuillard métallique tel que décrit ci-avant.

Selon un mode de réalisation, l'élément électrochimique est choisi parmi :

- un élément électrochimique primaire au lithium, par exemple de type $LiCF_x$,
- un élément électrochimique secondaire de type lithium-ion à électrolyte liquide,
- un élément électrochimique secondaire lithium-ion à électrolyte solide,
- un élément électrochimique primaire ou secondaire de type sodium-ion,
- un élément électrochimique secondaire de type lithium-soufre, et
- un élément électrochimique de type sodium-soufre.

L'invention a également pour objet une pile à combustible comprenant au moins une plaque bipolaire comprenant au moins un feuillard tel que décrit ci-avant, caractérisé en ce que ce feuillard présente des canaux de distribution de gaz sur la au moins une face comprenant ladite couche.

L'invention a également pour objet un procédé de fabrication d'une couche d'un matériau comprenant un métal ou un alliage de métaux, du carbone et de l'hydrogène sur un feuillard métallique, ledit procédé comprenant les étapes de :

a) mise à disposition d'un substrat constitué d'un feuillard métallique,
b) décapage de l'une des faces du substrat par un bombardement d'ions issus de l'ionisation d'un gaz inerte,
c) dépôt par pulvérisation cathodique sur la face décapée du substrat d'un matériau comprenant :

- un métal ou un alliage de métaux,
- du carbone,
- de l'hydrogène,

et éventuellement de l'oxygène,
la pulvérisation cathodique étant réalisée avec une cible constituée dudit métal ou dudit alliage de métaux dans un mélange d'un gaz inerte et d'un hydrocarbure gazeux à la température de 25° C, ce mélange pouvant éventuellement contenir de l'azote.

Selon un mode de réalisation, le métal du matériau de l'étape c) est le titane.

Selon un mode de réalisation, le procédé consiste uniquement en les étapes a) à c).

Selon un mode de réalisation, le procédé ne comprend pas d'étape de recuit du feuillard métallique recouvert du matériau à l'issue de l'étape c).

Selon un mode de réalisation, l'hydrocarbure est l'acétylène.

Enfin, l'invention a pour objet un feuillard métallique obtenu par le procédé tel que décrit ci-avant.

**Brève description des figures**

[Fig. 1] indique pour chacun des feuillards 1 à 9, la perte de carbone dans la couche après immersion du feuillard dans un électrolyte organique maintenu à 60° C pendant trois semaines.

[Fig. 2] indique pour chacun des feuillards 1 à 9, la perte de titane dans la couche après immersion du feuillard dans un électrolyte organique maintenu à 60° C pendant trois semaines.

[Fig. 3] représente la valeur de la résistance interne des éléments A à I mesurée pour différents régimes de décharge allant de 2C à 10C pour une profondeur de décharge d'environ 50%.

[Fig. 4] représente la valeur de la capacité en décharge des éléments A à I mesurée pour différents régimes de décharge allant de C/5 à 10C.

[Fig. 5] représente les courbes de charge au régime de C/5 et de décharge au régime de 10C des éléments A, C, E, F et G.

[Fig. 6] représente la variation de la résistance interne des éléments A, C, D, F, H et I au cours d'un test de vieillissement consistant en 500 cycles de charge/décharge à température ambiante (charge à C, décharge à 2C) suivis d'un stockage des éléments à 60° C à un état de charge de 100%. La résistance interne est mesurée par application d'une impulsion en décharge au régime de 5C pendant 10 secondes, pour une profondeur de décharge d'environ 50%.

**Description des modes de réalisation**

a) Fabrication du feuillard :

Le procédé selon l'invention permet d'obtenir une couche du matériau sur un feuillard métallique. Il comprend :

a) une étape de décapage sous vide de la surface du feuillard puis
b) une étape de dépôt sous vide du matériau par pulvérisation cathodique («sputtering»).

Les étapes a) et b) sont effectuées dans une chambre de pulvérisation. Cette chambre comprend une cible, un support destiné à recevoir le feuillard jouant le rôle de substrat, et elle est munie d'un port d'entrée pour l'injection d'un gaz.

La cible est constituée du métal ou de l'alliage de métaux qui est l'un des constituants du matériau de la couche. Le métal peut être choisi parmi Ti, Cr, Zr, Fe et Ni, de préférence Ti. Les métaux de l'alliage sont au moins deux métaux choisis de préférence parmi Ti, Cr, Zr, Fe et Ni. Dans un mode de réalisation, le métal n'est ni Fe, ni Ni et l'alliage de métaux ne comprend pas Fe et/ou ne comprend pas Ni.

Le substrat est constitué du feuillard métallique. Le métal du feuillard est de préférence de l'aluminium ou un alliage à base d'aluminium. Il peut être également du cuivre ou un alliage à base de cuivre. L'épaisseur du feuillard est généralement inférieure ou égale à 50 $\mu$m. L'épaisseur minimale du feuillard est en général de 5 $\mu$m. L'épaisseur peut être supérieure ou égale à 10 $\mu$m, supérieure ou égale à 15 $\mu$m ou supérieure ou égale à 20 $\mu$m. Généralement, le feuillard a une épaisseur allant de 5 $\mu$m à 35 $\mu$m.

L'étape a) de décapage du substrat consiste à polariser le substrat et à bombarder sa surface par des ions provenant d'un gaz inerte ionisé (plasma). Le bombardement réduit, voire élimine la couche d'oxyde à la surface du feuillard. L'étape de décapage améliore l'adhésion de la couche au feuillard métallique.

L'étape b) de pulvérisation cathodique se caractérise en particulier par l'injection dans la chambre d'un mélange d'un gaz inerte et d'un hydrocarbure gazeux à une température de 20-30° C. A titre d'exemple, l'hydrocarbure peut être choisi dans le groupe consistant en le méthane, l'éthylène, le propane, l'acétylène ou un mélange de plusieurs de ces gaz. L'acétylène est préféré en raison de son rapport H/C faible. De préférence, le gaz inerte est l'argon. On fait d'abord le vide dans la chambre puis on injecte le mélange de gaz inerte et d'hydrocarbure. Le débit d'injection du mélange peut être modifié ainsi que sa composition. On applique une différence de potentiel entre la cible et les parois de la chambre. Sous l'effet de cette différence de potentiel, le mélange de gaz inerte et d'hydrocarbure s'ionise. Un plasma se forme. Les espèces du plasma chargées positivement se trouvent attirées par la cible et entrent en collision avec le métal ou l'alliage de métaux de celle-ci. Cette collision provoque la pulvérisation des atomes du métal ou de l'alliage de métaux de la cible. Ces atomes se condensent à la surface du feuillard. L'accumulation d'atomes à la surface du feuillard permet la formation progressive d'une couche mince d'un matériau comprenant le métal ou l'alliage de métaux, du carbone, de l'hydrogène et éventuellement de l'oxygène. Dans une recherche d'homogénéité de la couche, le feuillard peut être mis en rotation devant la cible pendant la pulvérisation cathodique. De manière optionnelle, de l'azote peut être injecté dans la chambre durant l'étape de pulvérisation cathodique, en plus de l'hydrocarbure gazeux. L'injection d'azote gazeux permet d'incorporer l'élément chimique azote dans la couche de matériau.

Le substrat peut être polarisé à un potentiel allant de -100 à -500 V, de préférence de -150 à -450 V, voire de -200 V à -400 V. Le substrat peut être polarisé en mode pulsé à une fréquence allant de 150 à 350 kHz, voire de 200 à 300 kHz, par exemple environ 250 kHz. Le substrat peut être polarisé à un potentiel allant de -200 à -500 V. Le débit d'hydrocarbure dépend des caractéristiques de l'enceinte utilisée (taille, pompage). Le débit peut varier de 2 à 50 sccm, ou de 2 à 25 sccm, ou encore de 5 à 20 sccm (1 sccm = 1 cm$^3$/min, dans des conditions standard de pression et de température). Le débit d'argon peut être d'environ 30 sccm. Il est possible d'atteindre des vitesses de croissance de la couche comprises entre 1 et 15 nm/min, ou de 2 à 10 nm/min, ou de 4 à 10 nm/min.

L'homme du métier sait adapter le débit du mélange de gaz inerte et d'hydrocarbure gazeux en fonction des caractéristiques de l'enceinte de dépôt comme la taille de la cible, la puissance de pulvérisationou encore le débit de pompage, pour obtenir un matériau dont les pourcentages atomiques du métal ou des métaux de l'alliage, du carbone, de l'hydrogène et de l'oxygène soient compris dans les plages requises, c'est-à-dire respectivement 10 à 60%, 35 à 70 %, 2 à 20 %, et au plus 10 %.

A la fin du dépôt, le feuillard est prélevé de la chambre. L'analyse de la nature des éléments chimiques présents dans la couche peut être effectuée par fluorescence X sur la surface du feuillard ou par spectroscopie à plasma à couplage inductif (ICP) ou par spectroscopie de rétrodiffusion de Rutherford (RBS). La teneur précise en hydrogène dans le matériau peut être mesurée au moyen de la technique d'analyse par détection du recul élastique (ERDA : Elastic Recoil Détection Analysis). La teneur précise en métal, en particulier le titane, peut être mesurée par la technique de spectroscopie de rétrodiffusion de Rutherford (RBS : Rutherford Backscattering Spectrometry). Les teneurs précises en oxygène et en carbone peuvent être mesurées par l'analyse de réaction nucléaire (NRA : Nuclear Reaction Analysis). La teneur en azote éventuellement présent dans le matériau peut être mesuré de façon précise par RBS.

Le matériau de la couche peut comprendre des éléments chimiques autres que le métal ou ceux contenus dans l'alliage, le carbone, l'hydrogène et éventuellement l'oxygène et l'azote. Ces autres éléments chimiques sont présents en général à raison de 2% ou moins de la quantité atomique des éléments chimiques constituant le matériau, de préférence à raison de 1% ou moins.

L'épaisseur de la couche va en général de 25 à 200 nm, ou de 30 à 150 nm, ou de 40 à 150 nm, ou de 50 à 150 nm, ou de 50 à 100 nm. L'épaisseur de la couche peut être mesurée par exemple sur un témoin en verre en masquant partiellement le substrat puis en mesurant la hauteur de marche avec un profilomètre modèle AlphaStep fabriqué par Tencor Instruments.

La résistivité électrique $\rho$ de la couche (en micro Ohm $\times$ mètre [$\mu\Omega \times$ m]) peut aller de 0,5 à 14 $\mu\Omega$.m, ou de 1 à 10 $\mu\Omega$.m, ou de 2 à 10 $\mu\Omega$.m, ou de 1 à 5 $\mu\Omega$.m. La résistivité de la couche peut être évaluée sur un témoin isolant électrique, par exemple une lame de verre porte-objet très mince, en mesurant la résistance de surface R$\square$ dite R «carré», en Ohm [$\Omega$], avec un instrument de mesure 4 pointes de type Lucas Labs S-302-6 puis en multipliant R$\square$ par l'épaisseur de la couche (en m). La dispersion des mesures est de l'ordre de 5 à 10% pour des valeurs de résistivité comprises entre 2 $\mu\Omega$.m et 30 $\mu\Omega$.m.

b) Fabrication de la cathode :

La description qui suit est faite en référence à la cathode d'un élément secondaire de type lithium-ion à électrolyte liquide. Mais il est entendu que l'invention ne se limite pas à la fabrication d'une cathode d'un élément secondaire de type lithium-ion à électrolyte liquide. Elle peut s'appliquer à la fabrication d'une électrode négative (anode). Elle peut s'appliquer à la fabrication d'une électrode pour un élément électrochimique autre qu'un élément secondaire de type lithium-ion à électrolyte liquide. L'invention peut par exemple être appliquée dans la réalisation de collecteurs de courant destinés à être utilisés dans la fabrication des éléments suivants:

- un élément primaire au lithium, par exemple de type LiCF$_x$,
- un élément secondaire de type lithium-ion à électrolyte solide,
- un élément primaire ou secondaire de type sodium-ion à électrolyte liquide ou solide,

- un élément secondaire de type lithium-soufre, et
- un élément de type sodium-soufre.

L'invention peut être appliquée à la réalisation de collecteurs de courant destinés à être utilisés dans une électrode de supercondensateur ou dans une électrode de pile à combustible. L'invention peut également être appliquée à la réalisation de plaques distributrices de gaz de pile à combustible, encore appelées plaques bipolaires.

La ou les faces du feuillard revêtue(s) de la couche de matériau obtenu par le procédé selon l'invention est ou sont enduite(s) d'une composition de matière active cathodique. La composition de matière active cathodique comprend au moins une matière active cathodique, généralement au moins un liant et au moins un composé bon conducteur électronique. La composition de matière active cathodique peut être obtenue par un procédé par voie humide, c'est-à-dire par un procédé comprenant l'ajout d'un solvant aqueux ou organique à la composition de matière active. La composition de matière active cathodique peut aussi être obtenue par un procédé par voie sèche, c'est-à-dire sans incorporation de solvant.

Typiquement, pour la voie humide, on mélange la matière active cathodique, le liant, le composé conducteur électronique et le solvant. La composition de matière active est déposée par enduction sur le feuillard métallique servant de collecteur de courant. On obtient alors une électrode que l'on sèche pour évaporer le solvant.

La composition de matière active positive peut également être obtenue par voie sèche sans utiliser de solvant, en réalisant le mélange de la matière active, du liant et du composé bon conducteur électronique par une extrudeuse.

L'électrode obtenue par voie sèche ou humide est ensuite soumise à une étape de calandrage au cours de laquelle l'épaisseur de la couche de composition de matière active déposée est ajustée. La couche de composition de matière active déposée a une épaisseur après calandrage généralement comprise entre 25 $\mu$m et 300 $\mu$m. La quantité de composition de matière active sèche déposée sur le collecteur de courant varie généralement de 5 mg/cm$^2$/face à 50 mg/cm$^2$/face, ce qui permet de réaliser un générateur convenant pour des applications nécessitant une forte puissance ou des applications nécessitant une forte énergie.

La matière active cathodique de l'élément n'est pas particulièrement limitée. Elle peut être choisie dans le groupe consistant en :

- un composé **i)** de formule $Li_xMn_{1-y-z}M'_yM''_zPO_4$ (LMP), où M' et M" sont différents l'un de l'autre et sont choisis dans le groupe consistant en B, Mg, Al, Si, Ca, Ti, V, Cr, Fe, Co, Ni, Cu, Zn, Y, Zr, Nb et Mo, avec $0,8{\leq}x{\leq}1,2$ ; $0{\leq}y{\leq}0,6$ ; $0{\leq}z{\leq}0,2$;
- un composé **ii)** de formule $L'_xM_{2-x-y-z-w}M'_yM''_zM'''_wO_2$ (LM02), où M, M', M" et M''' sont choisis dans le groupe consistant en B, Mg, Al, Si, Ca, Ti, V, Cr, Mn, Fe, Co, Ni, Cu, Zn, Y, Zr, Nb, W et Mo, à la condition que M ou M' ou M" ou M''' soit choisi parmi Mn, Co, Ni, or Fe ; M, M', M" et M''' étant différents les uns des autres ; avec $0,8{\leq}x{\leq}1,4$ ; $0{\leq}y{\leq}0,5$ ; $0{\leq}z{\leq}0,5$; $0{\leq}w{\leq}0,2$ et $x+y+z+w<2,2$ ;
- un composé **iii)** de formule $Li_xMn_{2-y-z}M'_yM''_zO_4$ (LMO), où M' et M" sont choisis dans le groupe consistant en B, Mg, Al, Si, Ca, Ti, V, Cr, Fe, Co, Ni, Cu, Zn, Y, Zr, Nb et Mo; M' et M" étant différents l'un de l'autre, et $1{\leq}x{\leq}1,4$ ; $0{\leq}y{\leq}0,6$ ; $0{\leq}z{\leq}0,2$ ;
- un composé **iv)** de formule $Li_xFe_{1-y}M_yPO_4$, où M est choisi dans le groupe consistant en B, Mg, Al, Si, Ca, Ti, V, Cr, Mn, Co, Ni, Cu, Zn, Y, Zr, Nb et Mo; et $0,8{\leq}x{\leq}1,2$ ; $0{\leq}y{\leq}0,6$;
- un composé **v)** de formule $xLi_2MnO_3$; $(1-x)LiMO_2$ où M est choisi parmi Ni, Co et Mn et $x{\leq}1$, ou un mélange des composés **i)** à **v)**.

Un exemple de composé **i)** est $LiMn_{1-y}Fe_yPO_4$. Un exemple préféré est $LiMnPO_4$.

Le composé **ii)** peut avoir pour formule $L'_xM_{2-x-y-z-w}M'_yM''_zM'''_wO_2$, où $1 \leq x \leq 1,15$ ; M désigne Ni ; M' désigne Mn ; M" désigne Co et M''' est choisi dans le groupe consistant en B, Mg, Al, Si, Ca, Ti, V, Cr, Fe, Cu, Zn, Y, Zr, Nb, Mo ou un mélange de ceux-ci ; $2-x-y-z-w>0$ ; $y>0$ ; $z>0$ ; $w{\geq}0$.

Le composé **ii)** peut avoir pour formule $LiNi_{1/3}Mn_{1/3}Co_{1/3}O_2$

Le composé **ii)** peut aussi avoir pour formule $L'_xM_{2-x-y-z-w}M'_yM''_zM'''_wO_2$, où $1 \leq x \leq 1,15$ ; M désigne Ni ; M' désigne Co ; M" désigne Al et M''' est choisi dans le groupe consistant en B, Mg, Si, Ca, Ti, V, Cr, Fe, Cu, Zn, Y, Zr, Nb, Mo ou un mélange de ceux-ci ; $2-x-y-z-w>0$ ; $y>0$ ; $z>0$ ; $w{\geq}0$. De préférence, $x=1$ ; $0,6{\leq}2-x-y-z{\leq}0,85$ ; $0,10{\leq}y{\leq}0,25$ ; $0,05{\leq}z{\leq}0,15$ et $w=0$.

Le composé **ii)** peut aussi être choisi parmi $LiNiO_2$, $LiCoO_2$, $LiMnO_2$, Ni, Co et Mn pouvant être substitués par l'un ou par plusieurs des éléments choisis dans le groupe comprenant Mg, Mn (sauf pour $LiMnO_2$), Al, B, Ti, V, Si, Cr, Fe, Cu, Zn, Zr.

Un exemple de composé **iii)** est $LiMn_2O_4$.

Un exemple de composé **iv)** est $LiFePO_4$.

Un exemple de composé **v)** est $Li_2MnO_3$.

La matière active cathodique peut être recouverte au moins partiellement par une couche de carbone.

Le liant peut être choisi parmi la carboxyméthylcellulose (CMC), un copolymère de butadiène - styrène (SBR), le polytétrafluoroéthylène (PTFE), le polyamideimide (PAI), le polyimide (PI), le caoutchouc styrène-butadiène (SBR), les poly(acide acrylique) (PAA), l'alcool polyvinylique, le polyfluorure de vinylidène (PVDF) et un mélange de ceux-ci.

Le composé conducteur électronique est généralement du noir de carbone.

Une composition typique de matière active déposée sur le feuillard métallique peut être la suivante :

- de 75 à 90% en masse de matière active cathodique, de préférence de 80 à 90 %
- de 5 à 15% en masse de liant(s), de préférence 10 % ;
- de 5 à 10% en masse de noir de carbone, de préférence 10 %

c) Fabrication de l'anode :

On mélange une matière active anodique avec un ou plusieurs des liants, tels que ceux cités ci-avant, un solvant et généralement un ou plusieurs composés ayant des propriétés de conduction électrique élevée, tel que le noir de carbone. On obtient une composition de matière active que l'on dépose sur l'une ou les deux faces d'un collecteur de courant. Le collecteur de courant enduit de la composition de matière active est laminé afin d'ajuster son épaisseur. Une anode est ainsi obtenue.

La composition de matière active déposée sur le collecteur de courant de l'anode peut être la suivante :

- de 75 à 90 % de matière active anodique, de préférence de 80 à 85 % ;
- de 5 à 15 % de liant(s), de préférence 10 % ;
- de 5 à 10 % de carbone, de préférence 7,5 %.

La matière active anodique peut être choisie dans le groupe consistant en :

i) un composé à base de carbone, tel que le graphite ;
ii) un oxyde lithié de titane, tel que $Li_4Ti_5O_{12}$ ;
iii) un métal choisi parmi le lithium, l'aluminium, le silicium, l'étain, de préférence le silicium, et des alliages contenant ces métaux, de préférence un alliage de lithium.

d) Fabrication de l'élément :

On forme un faisceau électrochimique en intercalant un séparateur entre une anode et une cathode. On insère le faisceau électrochimique dans le conteneur de l'élément. Le conteneur de l'élément peut être de format parallélépipèdique ou cylindrique. Dans le cas d'un élément de format cylindrique, on enroule le faisceau électrochimique pour former une spirale et on insère cette spirale dans un conteneur cylindrique. On remplit le conteneur muni du faisceau électrochimique d'un électrolyte comprenant au moins un solvant organique et au moins un sel de lithium.

L'élément électrochimique peut servir de source d'énergie électrique à des véhicules hybrides ou électriques. Il peut également servir dans d'autres domaines, tels que l'alimentation de dispositifs de télécommunication, l'éclairage de secours, le ferroviaire, l'aviation, l'alimentation de dispositifs électriques ou électroniques portatifs.

EXEMPLES

Différents feuillards d'aluminium 1 à 9 ont été revêtus d'une couche d'un matériau comprenant les éléments Ti, C, H et éventuellement O. Au cours de l'étape de pulvérisation cathodique, le feuillard, qui sert de substrat, était monté sur une pièce en forme de tonneau, mise en rotation, permettant ainsi un dépôt homogène de la couche. La distance entre le feuillard et la cible était de 100 mm environ. Le feuillard était polarisé en mode pulsé à une fréquence de 250 kHz. La puissance appliquée sur la cible de titane était de 6 kW. Le débit d'argon était de 30 cm³/min à des conditions standard de température et de pression. Le débit d'acétylène était régulé par détection de l'émission lumineuse du plasma afin d'obtenir la composition souhaitée. Pour l'assistance ionique à la croissance du dépôt, une source de plasma supplémentaire était alimentée par une puissance de 430 W.

Les différentes couches des feuillards en aluminium ont été réalisées en faisant varier les paramètres suivants : le débit d'acétylène $C_2H_2$, la tension de polarisation du substrat en aluminium et la vitesse de dépôt de la couche. La composition des différentes couches ainsi que les conditions opératoires permettant leur fabrication sont indiquées Tableau 1. L'épaisseur des différentes couches et leur résistivité sont indiquées Tableau 2.

[Tableau 1]

| Référence feuillard | débit $C_2H_2$ (sccm) | Tension de polarisation du substrat (V) | Vitesse de dépôt (nm/min) | Pourcentages atomiques déterminés par RBS, ERDA et NRA | | | |
|---|---|---|---|---|---|---|---|
| | | | | Ti | C | H | O |
| 1* | 5 | 0 | 11,0 | 75,2 | 16,90 | 6,40 | 1,50 |
| 2* | 5 | -200 | 9,0 | 65,1 | 31,10 | 1,00 | 2,80 |
| 3* | 10 | 0 | 11,0 | 54,4 | 33,80 | 12,80 | <1% |
| 4 | 10 | -200 | 9,5 | 48,6 | 45,60 | 3,70 | 2,10 |
| 5 | 12,5 | -200 | 4,0 | 42,9 | 51,50 | 5,60 | <1% |
| 6 | 12,5 | -200 | 5,0 | 42,9 | 51,50 | 5,60 | <1% |
| 7* | 12,5 | 0 | 8,5 | 27 | 42,20 | 16,00 | 14,80 |
| 8 | 20 | -200 | 3,5 | 15,8 | 66,70 | 13,80 | 3,70 |
| 9* | 20 | 0 | 1,8 | 0 | 69,90 | 26,10 | 4,00 |
| * exemple ne faisant pas partie de l'invention | | | | | | | |

[Tableau 2]

| Référence feuillard | Epaisseur (nm) | Résistivité ($\mu\Omega.m$) |
|---|---|---|
| 1 | 110 | 2,5 |
| 2 | 90 | 1,9 |
| 3 | 110 | 8,8 |
| 4 | 95 | 2,7 |
| 5 | 55 | 2,2 |
| 6 | 100 | 2,4 |
| 7 | 170 | 21 |
| 8 | 140 | 20 |
| 9 | 35 | 27 |

A) Test de la stabilité des feuillards au contact de l'électrolyte à 60°C :

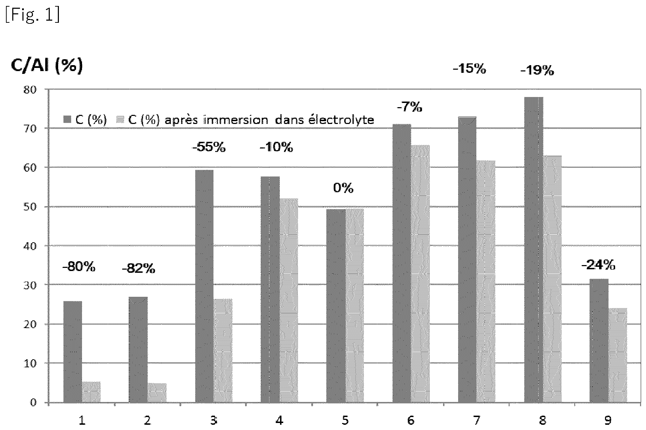

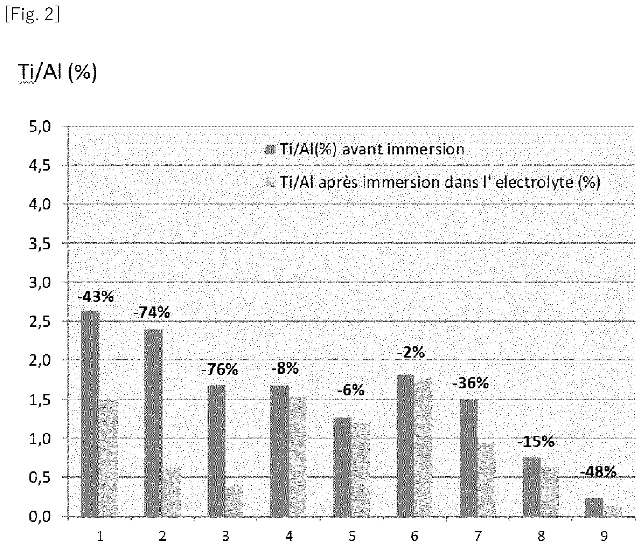

Les feuillards 1 à 9 ont été immergés dans un électrolyte à base de carbonates, à 60°C pendant 3 semaines puis analysés par fluorescence X après immersion. Les pertes en carbone, titane et oxygène dues à une dissolution progressive de la couche au contact de l'électrolyte ont été mesurées. La perte de carbone et de titane est évaluée en comparant les pourcentages massiques C/Al et Ti/Al avant et après immersion. Les valeurs des pertes de carbone et de titane sont représentées respectivement aux Figures 1 et 2.

Les résultats de ce test montrent que :

- la perte de carbone est inférieure à 20% pour les feuillards 4, 5, 6 et 8,
- la perte de carbone est d'au moins 24% pour les feuillards 1, 2, 3 et 9.
- la perte de titane est inférieure ou égale à 15% pour les feuillards 4, 5, 6 et 8
- la perte de titane est d'au moins 43% pour les feuillards 1, 2, 3 et 9.

La surface du feuillard 7 montre un changement de coloration après immersion dans l'électrolyte. Ce changement de couleur pourrait traduire une modification de la surface de la couche de matériau qui pourrait s'expliquer par un pourcentage atomique élevé en oxygène (14,80%). De plus, on peut noter que la couche de matériau du feuillard 7 perd une quantité notable de titane (36%).

Les feuillards présentant la meilleure stabilité vis-à-vis de l'électrolyte sont donc les feuillards 4, 5, 6 et 8. En particulier, les feuillards 4, 5 et 6 présentent une perte de carbone ou de titane ne dépassant pas 10%.

B) Evaluation en éléments lithium-ion de format 18650

Différents feuillards ont été utilisés dans la fabrication de cathodes d'éléments lithium-ion de format 18650. La Tableau 3 récapitule les caractéristiques des feuillards utilisés dans les différents éléments testés.

[Tableau 3]

| Série | Elément | Feuillard de la cathode | Tension de polarisation du substrat (feuillard) |
|---|---|---|---|
| 1 | A | Feuillard en aluminium nu | - |
| | B | | |
| 2 | C | Feuillard selon l'invention comprenant sur ses deux faces une couche d'un matériau comprenant Ti, C, H et O | -300 V |
| | D | | |
| 3 | E | Feuillard selon l'invention comprenant sur ses deux faces une couche d'un matériau comprenant Ti, C, H et O | -500 V |
| | F | | |
| 4 | G | Feuillard de référence comprenant sur ses deux faces une couche de carbone de 1,9 $\mu$m d'épaisseur | - |
| | H | | |
| | I | | |

La composition de matière active déposée sur chacun des feuillards de cathode des éléments A à I comprenait une matière active constituée d'un phosphate lithié de fer, de formule $LiFePO_4$, un percolant électrique à base de noir de carbone, un liant à base de polyfluorure de vinylidène (PVdF). La densité de la composition de matière active déposée sur le feuillard, c'est-à-dire, le grammage de l'électrode était de 10,5 mg/cm$^2$/face.

L'anode était constituée d'un mélange de graphite, de liant et d'épaississants enduits sur un collecteur de courant qui était un feuillard en cuivre. Les faisceaux électrochimiques différents ont été constitués en intercalant un séparateur entre la cathode et l'anode. Chaque faisceau a été spiralé et introduit dans le conteneur de l'élément. Chaque conteneur a été rempli d'électrolyte organique.

Les performances électriques des éléments C à F des séries 2 et 3 selon l'invention ont été comparées à celles d'éléments dont les deux faces du feuillard de la cathode étaient nues (éléments A et B de la série 1) et à celles d'éléments dont les deux faces du feuillard de la cathode étaient recouvertes d'une couche de carbone de 1,9 $\mu$m (éléments G à I de la série 4).

B-1) Mesure de la résistance interne :

La résistance interne de chaque élément a été mesurée. Pour réaliser cette mesure, on a effectué un cycle de référence constitué d'une charge puis d'une décharge au régime de C/5, où C est la capacité nominale de l'élément. Au cours de la décharge, on a effectué, pour un état de charge de l'élément voisin de 50%, plusieurs impulsions de décharge d'une durée chacune de 10 secondes à des régimes allant de 2C à 10C. Ces impulsions ont permis de calculer la résistance interne Ri en appliquant la formule :

[Math 1]

$$Ri = (U_{C/5} - U_{régime})/I_{régime}$$

où

$U_{C/5}$ désigne la tension de l'élément en décharge au régime de C/5 avant l'application de l'impulsion de décharge

$U_{régime}$ désigne la tension de l'élément à l'issue des 10 secondes d'application de l'impulsion de décharge au régime de décharge $I_{régime}$

La résistance interne est ensuite multipliée par la surface de cathode enduite sur le feuillard pour obtenir une résistance exprimée en $\Omega \times cm^2$.

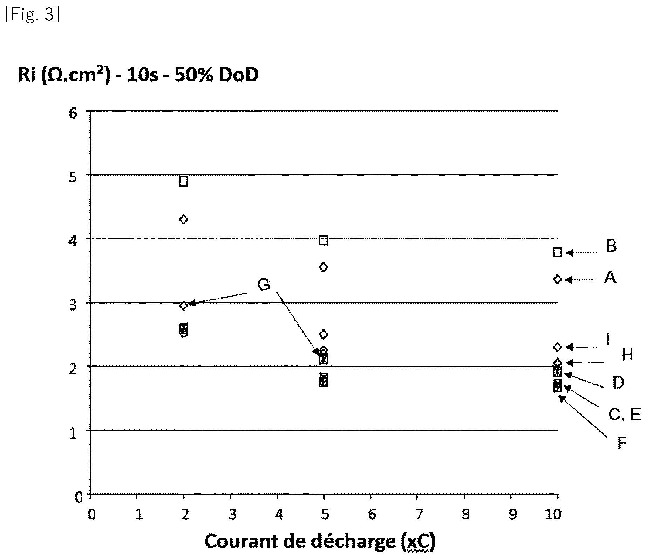

La figure 3 représente la valeur de la résistance interne des éléments A à I des séries 1 à 4 pour différents régimes de décharge allant de 2C à 10C. On constate que les éléments présentent la résistance interne la plus élevée sont les éléments A et B dont la cathode comporte un feuillard nu. La présence d'une couche comprenant le matériau selon l'invention ou d'une couche de carbone sur le feuillard de la cathode induit une baisse de la résistance interne de l'élément. Les éléments G, H et I dont la cathode comporte un feuillard recouvert d'une couche de carbone présentent une résistance interne inférieure d'environ 40% à celle des éléments A et B. Les éléments C, D, E et F selon l'invention présentent une résistance interne encore plus faible que celle des éléments G, H et I.

B-2) Mesure de la capacité de l'élément pour différents régimes de décharge:

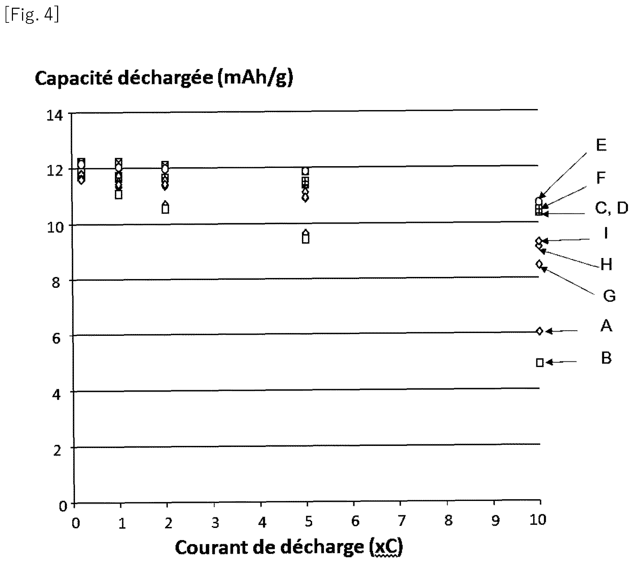

Les éléments A à I ont été soumis à un test électrique afin d'évaluer leur capacité. Ce test comprend une charge des éléments au régime de C/5 suivie d'une décharge à un régime compris entre C/5 à 10C. Les capacités déchargées en mAh par gramme de matière active de $LiFePO_4$ pour chaque régime de décharge sont représentées figure 4. On constate que les éléments A et B dont la cathode comprend un feuillard nu présentent la capacité la plus faible. Une nette amélioration de la capacité déchargée est observée lorsque le feuillard de la cathode est recouvert soit d'une couche de carbone, soit d'une couche comprenant le matériau selon l'invention. Cette amélioration s'explique par le fait que la présence d'une couche à la surface du feuillard de la cathode réduit la résistance de contact avec la matière active. Une couche comprenant le matériau selon l'invention réduit davantage la polarisation de l'électrode qu'une couche à base de carbone. La figure 4 met en évidence l'amélioration de la capacité des éléments dont le feuillard de cathode comporte une couche conductrice, par rapport à un élément dont le feuillard de cathode est nu :

- au régime de décharge de 2C : l'augmentation de capacité est de 10% pour les feuillards revêtus du matériau selon l'invention et de 9,4% pour les feuillards revêtus de carbone.
- au régime de décharge de 5C : l'augmentation de capacité est de 19% pour les feuillards revêtus du matériau selon l'invention et de 16% pour les feuillards revêtus de carbone.
- au régime de décharge de 10C : l'augmentation de capacité est de 72% pour les feuillards revêtus du matériau selon l'invention et de 51% pour les feuillards revêtus de carbone.

Le bénéfice de la présence de la couche du matériau selon l'invention se manifeste donc davantage à un régime élevé de décharge qu'à un faible régime.

B-3) Mesure de la polarisation des éléments :

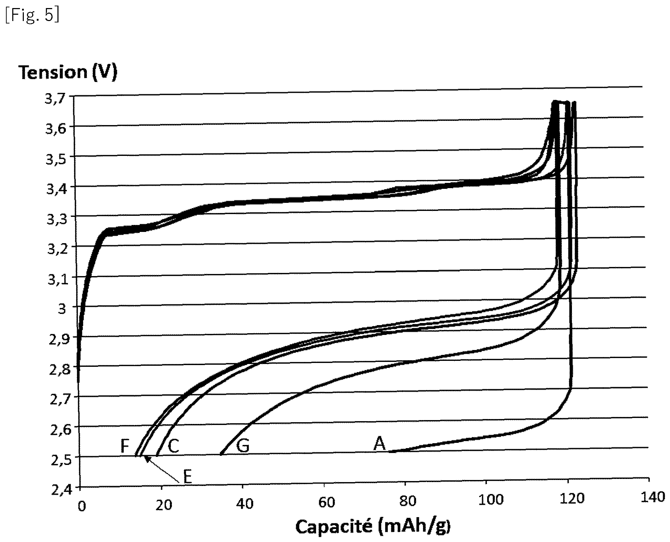

Les courbes de charge au régime de C/5 et de décharge au régime de 10C des éléments A, C, E, F et G ont été tracées. La polarisation de l'élément qui est la différence de tension entre la tension en charge et la tension en décharge pour un état de charge donné de l'élément peut ainsi être évaluée. Ces courbes sont représentées à la figure 5. On constate que les éléments C, E, F et G dont le feuillard de la cathode comporte une couche de carbone ou une couche du matériau selon l'invention, présentent une polarisation plus faible que l'élément A dont le feuillard de la cathode est nu. Les éléments C, E et F dont la cathode comprend un feuillard revêtu du matériau selon l'invention présentent une polarisation plus faible que celle de l'élément G dont la cathode comprend un feuillard recouvert de carbone.

B-4) Etude du vieillissement des éléments :

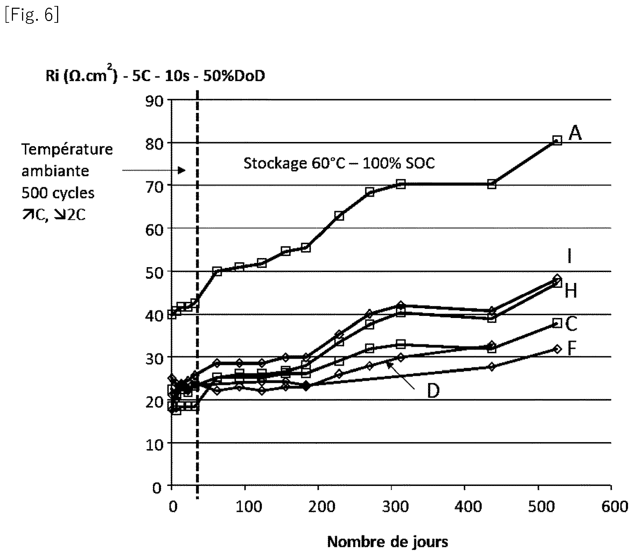

Les éléments A, C, D, F, H et I ont ensuite subi un test de vieillissement consistant en la réalisation de 500 cycles de charge/décharge à température ambiante (charge à C, décharge à 2C) suivis d'un stockage à 60°C à 100% d'état de charge. La résistance interne a été mesurée périodiquement au cours des 500 cycles de charge/décharge ainsi que pendant le stockage à 60°C, selon les conditions de mesure décrites au paragraphe B-1, pour une impulsion de décharge au régime de 5C. La variation de la résistance interne des éléments au cours du test de vieillissement est représentée figure 6. On constate que :

- au début du test, la résistance interne de l'élément A dont le feuillard de la cathode est nu est la plus élevée (40 $\Omega \times cm^2$). La résistance interne des éléments H et I dont le feuillard de la cathode est revêtu de carbone est d'environ

22 à 25 $\Omega\times$cm$^2$. Les éléments C, D et F dont le feuillard de la cathode est revêtu du matériau selon l'invention présentent une résistance interne d'environ 20 $\Omega\times$cm$^2$, qui est plus faible que celle des éléments H et I.
- la résistance interne des éléments C, D et F selon l'invention augmente moins vite au cours du test que celle des éléments A, H et I et elle reste inférieure en fin de test à celle de l'élément A en début de test.

La couche selon l'invention résiste donc bien au vieillissement, aussi bien lorsque l'élément est utilisé dans des conditions de cyclage que dans des conditions de stockage à haute température.

**Revendications**

1. Feuillard métallique comprenant sur au moins l'une de ses faces une couche d'un matériau comprenant :

   - un métal ou un alliage de métaux,
   - du carbone,
   - de l'hydrogène,

   et éventuellement de l'oxygène,
   le pourcentage atomique du métal ou des métaux de l'alliage dans le matériau allant de 10 à 60%,
   le pourcentage atomique de carbone dans le matériau allant de 35 à 70 %,
   le pourcentage atomique d'hydrogène dans le matériau allant de 2 à 20 %,
   le pourcentage atomique d'oxygène si présent dans le matériau étant inférieur ou égal à 10 %.

2. Feuillard métallique selon la revendication 1, dans lequel le matériau comprend en outre de l'azote.

3. Feuillard métallique selon la revendication 1 ou 2, dans lequel le pourcentage atomique du métal ou des métaux de l'alliage dans le matériau va de 30 à 50%, de préférence de 40 à 50%.

4. Feuillard métallique selon l'une des revendications précédentes, dans lequel le pourcentage atomique de carbone dans le matériau va de 40 à 60%, de préférence de 45 à 55%.

5. Feuillard métallique selon l'une des revendications précédentes, dans lequel le pourcentage atomique d'hydrogène dans le matériau va de 3 à 15%, de préférence de 3 à 8%.

6. Feuillard métallique selon l'une des revendications précédentes, dans lequel le matériau comprend de l'oxygène, et le pourcentage atomique d'oxygène dans le matériau est inférieur ou égal à 5%, de préférence inférieur ou égal à 2%, de préférence encore inférieur ou égal à 1%.

7. Feuillard métallique selon l'une des revendications 3 à 6, dans lequel :

   - le pourcentage atomique du métal ou des métaux de l'alliage dans le matériau va de 40 à 50%,
   - le pourcentage atomique de carbone dans le matériau va de 40 à 55 %,
   - le pourcentage atomique d'hydrogène dans le matériau va de 3 à 8 %, et
   - le pourcentage atomique d'oxygène dans le matériau est inférieur ou égal à 5 %.

8. Feuillard métallique selon l'une des revendications précédentes, dans lequel le métal du matériau est choisi parmi Ti, Cr, Zr, Fe, Ni, de préférence Ti.

9. Feuillard métallique selon l'une des revendications 1 à 7, dans lequel l'alliage du matériau est composé de plusieurs métaux choisis parmi Ti, Zr, Fe, Cr et Ni.

10. Feuillard métallique selon l'une des revendications précédentes, dans lequel l'épaisseur de la couche va de 30 à 200 nm ou va de 50 à 150 nm ou va de 50 à 100 nm.

11. Feuillard métallique selon l'une des revendications précédentes, en aluminium ou en alliage à base d'aluminium, ou en cuivre ou en alliage à base de cuivre.

12. Cathode d'un élément électrochimique comprenant un feuillard selon la revendication 11.

**13.** Elément électrochimique comprenant une cathode et une anode, la cathode ou l'anode comprenant un feuillard métallique selon l'une des revendications 1 à 11.

**14.** Elément électrochimique selon la revendication 13, choisi parmi :

- un élément électrochimique primaire au lithium, par exemple de type LiCF$_x$,
- un élément électrochimique secondaire de type lithium-ion à électrolyte liquide,
- un élément électrochimique secondaire lithium-ion à électrolyte solide,
- un élément électrochimique primaire ou secondaire de type sodium-ion,
- un élément électrochimique secondaire de type lithium-soufre, et
- un élément électrochimique de type sodium-soufre.

**15.** Pile à combustible comprenant au moins une plaque bipolaire comprenant au moins un feuillard selon l'une des revendications 1 à 11 **caractérisé en ce que** ce feuillard présente des canaux de distribution de gaz sur la au moins une face comprenant ladite couche.

**16.** Procédé de fabrication d'une couche d'un matériau comprenant un métal ou un alliage de métaux, du carbone et de l'hydrogène sur un feuillard métallique, ledit procédé comprenant les étapes de :

a) mise à disposition d'un substrat constitué d'un feuillard métallique,
b) décapage de l'une des faces du substrat par un bombardement d'ions issus de l'ionisation d'un gaz inerte,
c) dépôt par pulvérisation cathodique sur la face décapée du substrat d'un matériau comprenant :

- un métal ou un alliage de métaux,
- du carbone,
- de l'hydrogène,

et éventuellement de l'oxygène,
la pulvérisation cathodique étant réalisée avec une cible constituée dudit métal ou dudit alliage de métaux dans un mélange d'un gaz inerte et d'un hydrocarbure gazeux à la température de 25° C, ce mélange pouvant éventuellement contenir de l'azote.

**17.** Procédé selon la revendication 16, dans lequel le métal du matériau de l'étape c) est le titane.

**18.** Procédé selon la revendication 16 ou 17, dans lequel l'hydrocarbure est l'acétylène.

**19.** Procédé selon l'une des revendications 16 à 18, ne comportant pas d'étape de recuit.

[Fig. 1]

[Fig. 2]

Ti/Al (%)

[Fig. 3]

**Ri ($\Omega.cm^2$) - 10s - 50% DoD**

[Fig. 4]

**Capacité déchargée (mAh/g)**

[Fig. 5]

[Fig. 6]

Europäisches
Patentamt

European
Patent Office

Office européen
des brevets

## RAPPORT DE RECHERCHE EUROPEENNE

Numéro de la demande

EP 20 15 8171

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 107 419 220 A (NATIONAL KAOHSIUNG FIRST UNIV OF SCIENCE AND TECHNOLOGY) 1 décembre 2017 (2017-12-01) * pages 3,4,5,8; revendication 1 * ----- | 1,3-9, 11-19 | INV. C23C14/06 H01G11/00 H01M4/66 H01M4/86 |
| X | US 2015/001519 A1 (MATSUURA YOSHINORI [JP] ET AL) 1 janvier 2015 (2015-01-01) * page 1, alinéa 12 - page 5, alinéas 48,49,50 * ----- | 1,2,9, 10,14,17 | |
| X | DE 100 11 918 A1 (FEDERAL MOGUL BURSCHEID GMBH [DE]) 27 septembre 2001 (2001-09-27) * colonne 2, lignes 40-60 * ----- | 1,3-8 | |
| A | EP 2 680 286 A1 (JAPAN CAPACITOR IND CO LTD [JP]) 1 janvier 2014 (2014-01-01) * page 4, lignes 32,46-52 - page 5, lignes 23-24 * ----- | 1-19 | |
| A | US 2001/024598 A1 (SCHIER VEIT [DE]) 27 septembre 2001 (2001-09-27) * page 1, alinéa 20; revendications 1,3,4 * ----- | 1-19 | DOMAINES TECHNIQUES RECHERCHES (IPC) |
| A | US 2014/329070 A1 (DRAXLER MARKUS [AT] ET AL) 6 novembre 2014 (2014-11-06) * page 3, alinéas 36,41,42 - page 4, alinéa 53 * ----- | 1-19 | C23C H01G H01M |

Le présent rapport a été établi pour toutes les revendications

| Lieu de la recherche | Date d'achèvement de la recherche | Examinateur |
|---|---|---|
| La Haye | 10 mars 2020 | Boussard, Nadège |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 15 8171

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-03-2020

| Document brevet cité au rapport de recherche | Date de publication | Membre(s) de la famille de brevet(s) | Date de publication |
|---|---|---|---|
| CN 107419220 A | 01-12-2017 | AUCUN | |
| US 2015001519 A1 | 01-01-2015 | CN 104081880 A | 01-10-2014 |
| | | EP 2814303 A1 | 17-12-2014 |
| | | JP 2013161698 A | 19-08-2013 |
| | | US 2015001519 A1 | 01-01-2015 |
| | | WO 2013118325 A1 | 15-08-2013 |
| DE 10011918 A1 | 27-09-2001 | AUCUN | |
| EP 2680286 A1 | 01-01-2014 | AU 2012221308 A1 | 12-09-2013 |
| | | AU 2016277576 A1 | 12-01-2017 |
| | | CA 2827919 A1 | 30-08-2012 |
| | | CN 103380469 A | 30-10-2013 |
| | | CN 107403697 A | 28-11-2017 |
| | | EP 2680286 A1 | 01-01-2014 |
| | | HU E045264 T2 | 30-12-2019 |
| | | KR 20140010057 A | 23-01-2014 |
| | | RU 2013142759 A | 27-03-2015 |
| | | TW 201248664 A | 01-12-2012 |
| | | TW 201707027 A | 16-02-2017 |
| | | US 2013330617 A1 | 12-12-2013 |
| | | WO 2012115050 A1 | 30-08-2012 |
| US 2001024598 A1 | 27-09-2001 | AT 355398 T | 15-03-2006 |
| | | CN 1310067 A | 29-08-2001 |
| | | DE 10002861 A1 | 09-08-2001 |
| | | EP 1120473 A2 | 01-08-2001 |
| | | ES 2278651 T3 | 16-08-2007 |
| | | JP 2001232501 A | 28-08-2001 |
| | | KR 20010074523 A | 04-08-2001 |
| | | US 2001024598 A1 | 27-09-2001 |
| US 2014329070 A1 | 06-11-2014 | AT 511605 A4 | 15-01-2013 |
| | | CN 103987872 A | 13-08-2014 |
| | | DE 112012005168 A5 | 28-08-2014 |
| | | US 2014329070 A1 | 06-11-2014 |
| | | WO 2013086552 A1 | 20-06-2013 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110200884 A